Europäisches Patentamt

European Patent Office

Office européen des brevets

(11) Numéro de publication : **0 017 561**
**B1**

(12) # FASCICULE DE BREVET EUROPÉEN

(45) Date de publication du fascicule du brevet :
01.06.83

(51) Int. Cl.³ : **G 11 C 27/02**, **H 03 H 15/02**

(21) Numéro de dépôt : 80400400.0

(22) Date de dépôt : 26.03.80

(54) **Dispositif de lecture et d'injection de charges électriques et application d'un tel dispositif.**

(30) Priorité : 06.04.79 FR 7908788

(43) Date de publication de la demande :
15.10.80 Bulletin 80/21

(45) Mention de la délivrance du brevet :
01.06.83 Bulletin 83/22

(84) Etats contractants désignés :
DE GB NL

(56) Documents cités :
US A 3 858 232
US A 4 047 051

(73) Titulaire : **THOMSON-CSF**
**173, Boulevard Haussmann**
**F-75379 Paris Cedex 08 (FR)**

(72) Inventeur : **Berger, Jean-Luc**
**"THOMSON-CSF" SCPI 173, Bld Haussmann**
**F-75360 Paris Cedex 08 (FR)**
Inventeur : **Coutures, Jean-Louis**
**"THOMSON-CSF" SCPI 173, Bld Haussmann**
**F-75360 Paris Cedex 08 (FR)**
Inventeur : **Descure, Pierre**
**"THOMSON-CSF" SCPI 173, Bld Haussmann**
**F-75360 Paris Cedex 08 (FR)**

(74) Mandataire : **Benichou, Robert et al**
**THOMSON-CSF SCPI 173 bld Haussmann**
**F-75379 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

# 0 017 561

Dispositif de lecture et d'injection de charges électriques et application d'un tel dispositif

La présente invention concerne un dispositif de lecture et d'injection de charges électriques. Elle concerne également l'application d'un tel dispositif aux dispositifs à transfert de charges qui comportent un ou plusieurs filtres.

Dans de nombreux dispositifs à transfert de charges, il est nécessaire de lire une quantité de charges électriques puis d'injecter dans le dispositif une quantité de charges qui dépend de la quantité de charges lue précédemment.

C'est le cas par exemple des filtres récursifs où la quantité de charges injectée dans le filtre est égale à la différence entre la quantité de charges correspondant au signal à traiter et la quantité de charges lue précédemment.

Les filtres récursifs selon l'art antérieur comportent généralement un dispositif de lecture des charges, tel par exemple celui décrit par la demande de brevet français N° 77.13857, publié sous le numéro 2.839.899, au nom de THOMSON-CSF ; ce dispositif de lecture convertit les charges en un signal électrique, soit un courant, soit une tension, qui est envoyé sur l'entrée négative d'un amplificateur différentiel, connecté à l'entrée du filtre, qui reçoit sur son entrée positive le signal à traiter.

Les filtres récursifs selon l'art antérieur présentent de nombreux inconvénients, parmi lesquels on peut citer :

— le fait que le dispositif de lecture des charges et l'amplificateur différentiel présentent un gain propre qu'il est nécessaire de régler pour injecter dans le filtre une quantité de charges correspondant exactement à la différence entre la quantité de charges correspondant au signal à traiter et la quantité de charges lue précédemment ;

— l'encombrement du dispositif de lecture de charges et de l'amplificateur différentiel qu'il n'est pas toujours possible d'intégrer sur le même substrat que le filtre proprement dit, leur consommation élevée car ils comportent généralement des transistors MOS dont la consommation est très supérieure à celle des dispositifs à transfert de charges et enfin les non-linéarités susceptibles d'être introduites par les transistors MOS.

Lorsqu'on met en série plusieurs filtres transversaux, en vue d'obtenir des gabarits en fréquence avec une réjection élevée, ou plusieurs lignes à retard, il est également nécessaire de lire les charges en sortie de chaque filtre ou de chaque ligne à retard puis d'injecter la quantité de charges lue dans le filtre ou la ligne à retard suivants.

Dans l'art antérieur, on intercale entre deux filtres ou deux lignes à retard un dispositif de lecture des charges qui présente les inconvénients cités précédemment, d'encombrement, de consommation et de non-linéarité notamment.

On connaît par N° US-A-4.047.051 un dispositif de lecture et d'injection de charges électriques qui assure la lecture de charges dans un dispositif à transfert de charges, comportant un substrat semi-conducteur recouvert d'une couche isolante sur laquelle alternent des électrodes de transfert et des électrodes de stockage des charges. Ces électrodes assurent sur application de potentiels donnés le transfert des charges dans le substrat.

Ce dispositif comporte, en outre, une diode d'injection des charges qui est connectée électriquement à au moins une électrode de stockage des charges associée aux charges à lire, cette diode étant suivie par une grille de commande, de sorte que, lors de l'arrivée des charges sous les électrodes de stockage, les charges injectées par influence électrique sous la diode d'injection soient transférées au-dessous de ladite grille vers une électrode de stockage suivante.

Selon l'invention, la diode d'injection des charges et la grille de commande forment en combinaison avec une deuxième diode disposée à leur suite sur le substrat, un transistor MOS d'injection des charges polarisé en saturation. Cette deuxième diode qui constitue le drain de ce transistor MOS est reliée à un transistor qui est maintenu conducteur lors de l'arrivée des charges sous les électrodes de stockage, et donc lors de l'arrivée sous la source puis le drain du transistor d'injection des charges fournies par influence électrique. Un couple électrode de stockage-électrode de transfert est disposé en amont du transistor d'injection, selon le sens de transfert des charges, et assure le transfert sous la source du transistor d'injection d'une quantité de charges de référence, après le départ des charges des électrodes de stockage qui provoque par influence électrique une augmentation de potentiel sous la source du transistor d'injection des charges ; de sorte qu'une quantité de charges égale à la différence entre la quantité de charges de référence et la quantité de charges à lire est transférée sous le drain du transistor d'injection des charges, puis sous l'électrode de stockage suivante.

Le dispositif selon l'invention peut être notamment utilisé pour mettre en série plusieurs filtres transversaux ou plusieurs lignes à retard et pour réaliser le bouclage de filtres récursifs, d'un ordre quelconque, à coefficients positifs et négatifs ou de même signe.

Le dispositif selon l'invention présente de nombreux avantages parmi lesquels on peut citer :

— le fait qu'il ne nécessite pas de réglages externes ;

— son intégration sur le même substrat semi-conducteur que le dispositif à transfert de charges proprement dit ;

— sa grande stabilité et sa grande précision qui sont dues notamment au fait qu'il permet d'éviter la

2

double conversion de charges électriques en signal électrique et vice-versa ;

— le fait qu'il permette la lecture d'une quantité de charges Q puis l'injection d'une quantité de charges $Q_{ref} - Q_s$ ;

Des modes de réalisation de l'invention ressortiront de la description suivante, donnée à titre d'exemple non limitatif et illustrée par les figures annexées qui représentent :

la figure 1, une vue en coupe transversale d'un mode de réalisation du dispositif de lecture et d'injection et un schéma illustrant son fonctionnement ;

les figures 2a et 2b, une vue en coupe transversale d'un mode de réalisation du dispositif de lecture et d'injection selon l'invention et deux schémas illustrant son fonctionnement ;

la figure 3, un schéma d'un dispositif à transfert de charges ;

les figures 4a et 4b, une vue de dessus et une vue en coupe transversale d'un mode de réalisation selon l'invention du dispositif de la figure 3 et un schéma illustrant le fonctionnement de ce mode de réalisation ;

les figures 5a à 5e, des diagrammes de signaux susceptibles d'être appliqués aux dispositifs à transfert de charges comportant un dispositif de lecture et d'injection selon l'invention.

la figure 6, un autre schéma d'un dispositif à transfert de charges ;

la figure 7, une vue de dessus d'un mode de réalisation selon l'invention du dispositif de la figure 6.

Sur les différentes figures, les mêmes repères désignent les mêmes éléments, mais, pour des raisons de clarté, les cotes et proportions des différents éléments n'ont pas été respectées.

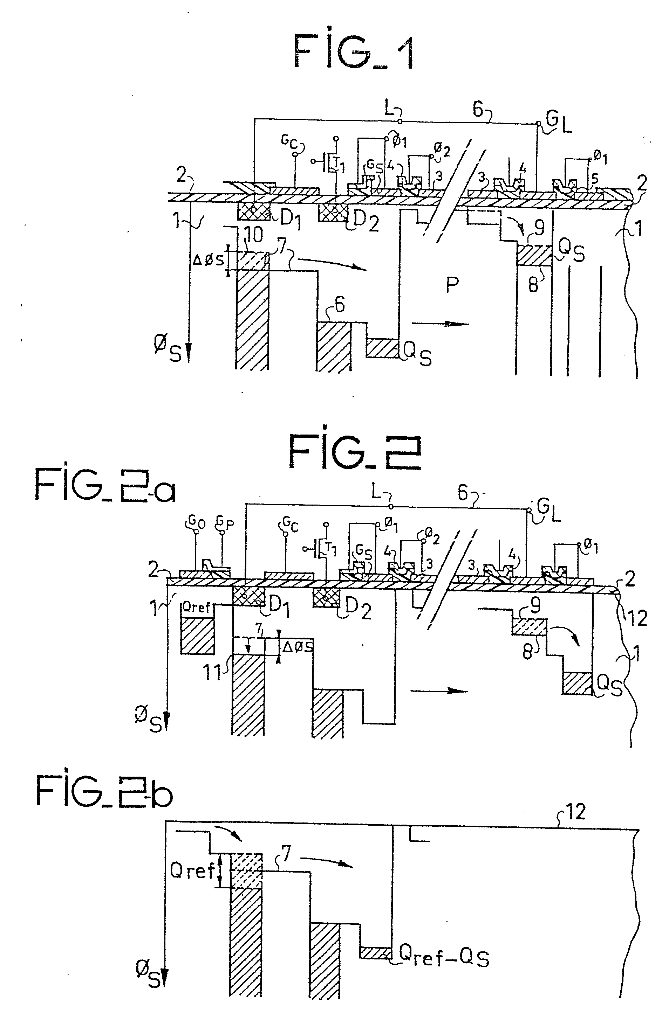

La figure 1 représente une vue en coupe transversale, selon la direction de propagation des charges d'un mode de réalisation du dispositif de lecture et d'injection des charges.

Un substrat semi-conducteur 1, en silicium de type P dans l'exemple, est recouvert d'une couche isolante 2, en oxyde de silicium dans l'exemple. Sur cette couche isolante 2, sont disposées des électrodes de stockage des charges 3, sensiblement normalement à la direction de propagation des charges indiquée par une flèche. Des électrodes de transfert des charges 4 alternent avec les électrodes de stockage. Les électrodes de transfert 4 sont déposées sur une surépaisseur d'isolant 5.

Ainsi qu'il est connu, cette disposition a une double fonction, d'une part assurer la continuité des potentiels créés dans le semi-conducteur 1, et d'autre part, imposer un sens de transfert unique pour les porteurs de charges.

Cette structure comportant une surépaisseur d'isolant peut être remplacée par un surdopage du substrat, par implantation d'ions, assurant les mêmes fonctions.

De même, la description est faite dans le cas de dispositifs à transfert de charges à deux phases $\phi_1$ et $\phi_2$ adressant chacune un couple électrode de transfert 4-électrode de stockage 3, mais peut s'appliquer aussi bien à des dispositifs à transfert de charges à trois phases par exemple.

Le dispositif de lecture et d'injection assure la lecture des charges transitant sous une ou plusieurs électrodes de stockage, qui peuvent être ou non partagées afin d'affecter de coefficients de pondération la charge lue.

Sur la figure 1, une seule électrode de stockage, appelée grille de lecture $G_L$, est connectée électriquement à la source d'un transistor MOS d'injection des charges.

Ce transistor d'injection est constitué de deux diodes $D_1$ et $D_2$ intégrées dans un dispositif à transfert de charges qui peut être ou non le même que celui dans lequel les charges sont lues. Ces dispositifs à transfert de charges sont généralement intégrés sur le même substrat semi-conducteur 1. Les diodes $D_1$ et $D_2$ sont par exemple des jonctions PN réalisées par dopage du substrat 1 de type P. Le transistor MOS d'injection comporte aussi une grille $G_C$, déposée sur la couche isolante 2 entre les deux diodes, qui commande le transfert des charges.

Avant l'arrivée des charges sous la grille de lecture $G_L$, le transistor d'injection est polarisé en saturation.

A cet effet, la grille de commande $G_C$ est maintenue à un potentiel constant $V_G$ et la diode $D_2$, qui suit la diode $D_1$ selon le sens de transfert des charges, est portée par un transistor MOS $T_1$ à un potentiel élevé supérieur à $V_G$. La diode $D_1$ qui constitue la source du transistor d'injection est seulement connectée à la grille de lecture $G_L$ par une connexion métallique 6 extérieure au substrat semi-conducteur 1 et qui est généralement en aluminium.

La figure 1 comporte également un schéma illustrant le fonctionnement du dispositif de lecture et d'injection des charges. Ce schéma représente l'évolution du potentiel de surface $\phi_S$ dans le substrat 1. Les zones hachurées indiquent la présence de porteurs minoritaires.

Les diodes $D_1$ et $D_2$ constituent en quelque sorte des sources de porteurs minoritaires, dont le niveau du potentiel de surface est représenté par une ligne 6 pour $D_2$ qui est polarisée par le transistor $T_1$ et par une ligne 7 pour $D_1$. Le potentiel de surface sous $D_1$ est aligné sur le potentiel de surface sous la grille de commande $G_C$ qui égale $V_G - V_T$, où $V_G$ est la tension de polarisation de $G_C$ et $V_T$ la tension de seuil sous $G_C$.

Au moment de l'arrivée d'une quantité de charges $Q_S$ sous $G_L$, le niveau du potentiel de surface sous $G_L$ diminue et passe de la ligne 8 à la ligne 9, représentée en trait discontinu. Par influence électrostatique due à la liaison électrique 6, le potentiel sous $D_1$ diminue de $\Delta\phi_S$ tel que : $\Delta\phi_S = Q_S/C_L$, où $C_L$ représente la capacité au point L, pris sur la liaison 6, par rapport au substrat. Le potentiel sous $D_1$ est alors représenté par la ligne 10, en trait discontinu.

3

**0 017 561**

Du fait de la barrière de potentiel existant sous $G_C$, le potentiel sous $D_1$ revient immédiatement au niveau 7 et la quantité de charges $Q_S$ est évacuée sous la diode $D_2$. Avant l'arrivée de la quantité de charges $Q_S$ sous $G_L$, le transistor $T_1$ a été bloqué, la quantité de charges $Q_S$ n'est donc pas évacuée par $T_1$ et se trouve transférée de la diode $D_2$ vers l'électrode de stockage suivante, commandée par la phase $\phi_1$, puis vers l'électrode de stockage suivante, commandée par la phase $\phi_2$, selon le principe classique du transfert de charges.

Le dispositif représenté sur la figure 1 permet donc la lecture d'une quantité de charges $Q_S$, puis l'injection de cette même quantité de charges. Il peut être notamment utilisé pour la mise en série de plusieurs lignes à retard ou de plusieurs filtres transversaux.

Le dispositif de lecture et d'injection des charges représenté en coupe transversale sur la figure 2a diffère de celui représenté sur la figure 1 parce qu'il comporte, en amont du transistor d'injection selon le sens de transfert des charges, un couple électrode de stockage-électrode de transfert.

Dans le cas de la figure 2, au moment de l'arrivée des charges sous $G_L$, le transistor $T_1$ est maintenu conducteur et le couple électrode de transfert-électrode de stockage qui suit $D_2$ et qui est repéré par $G_S$ est au niveau bas. La quantité de charges $Q_S$ qui est injectée sous $D_2$ est alors évacuée par le transistor $T_1$.

La lecture des charges va se faire lors du départ des charges de $G_L$. La figure 2a illustre l'évolution du potentiel de surface dans le substrat à ce moment-là. Lorsque le couple électrode de transfert-électrode de stockage adjacent à $G_L$, en aval de $G_L$ passe au niveau haut, la quantité de charges $Q_S$ quitte $G_L$. Le potentiel sous $G_L$ augmente alors et passe du niveau 9 au niveau 8. Par influence électrostatique, le potentiel sous $D_1$ passe du niveau 7 au niveau 11 et augmente de $\Delta\phi_S$ tel que $\Delta\phi_S = Q_S/C_L$. Le potentiel de surface sous $D_1$ (niveau 11) égale alors $V_G - V_T + \Delta\phi_S$.

Le couple électrode de stockage-électrode de transfert qui précède $D_1$, assure alors le transfert sous $D_1$ d'une quantité de charges préalablement stockée $Q_{réf}$. La figure 2b représente les potentiels dans le substrat après ce transfert.

Sur la figure 2b, on a seulement représenté l'interface du substrat 1 avec l'isolant 2.

La quantité de charges $Q_{réf}$ comble le puits de potentiel existant sous la diode $D_1$ jusqu'au niveau 7 correspondant à la barrière de potentiel $V_G - V_T$ imposée par $G_C$ et l'excédent, soit la quantité de charges $Q_{réf} - Q_S$, passe sous la diode $D_2$, puis sous les électrodes de stockage suivantes.

Le dispositif représenté sur les figures 2a et 2b permet donc la lecture d'une quantité de charges $Q_S$, puis l'injection d'une quantité de charges $Q_{réf} - Q_S$.

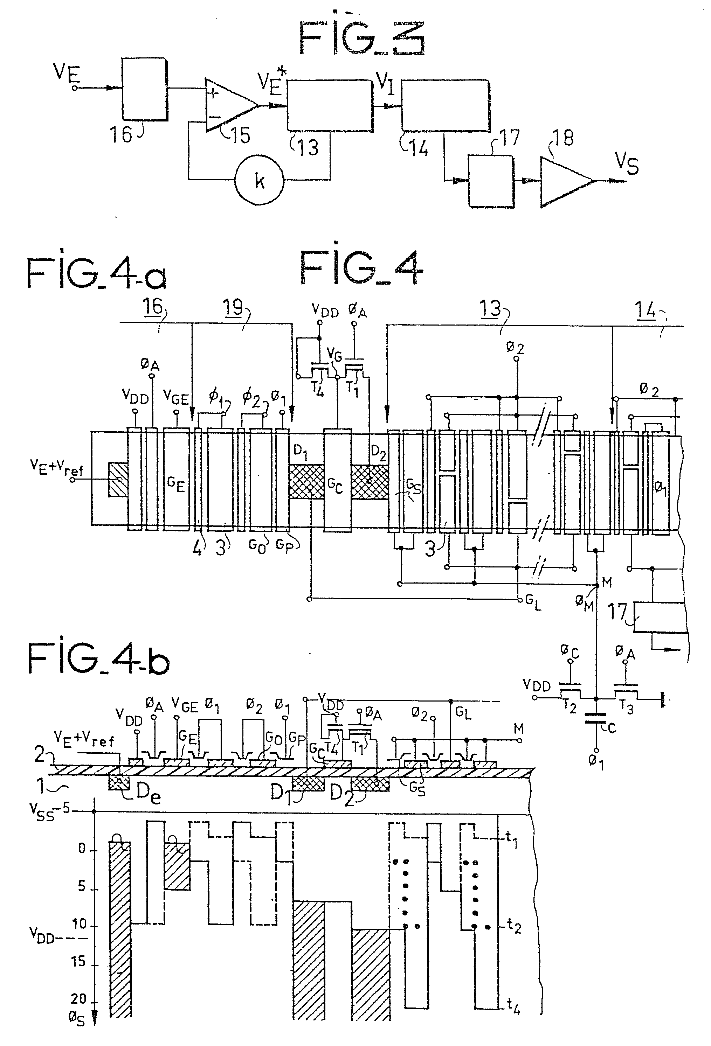

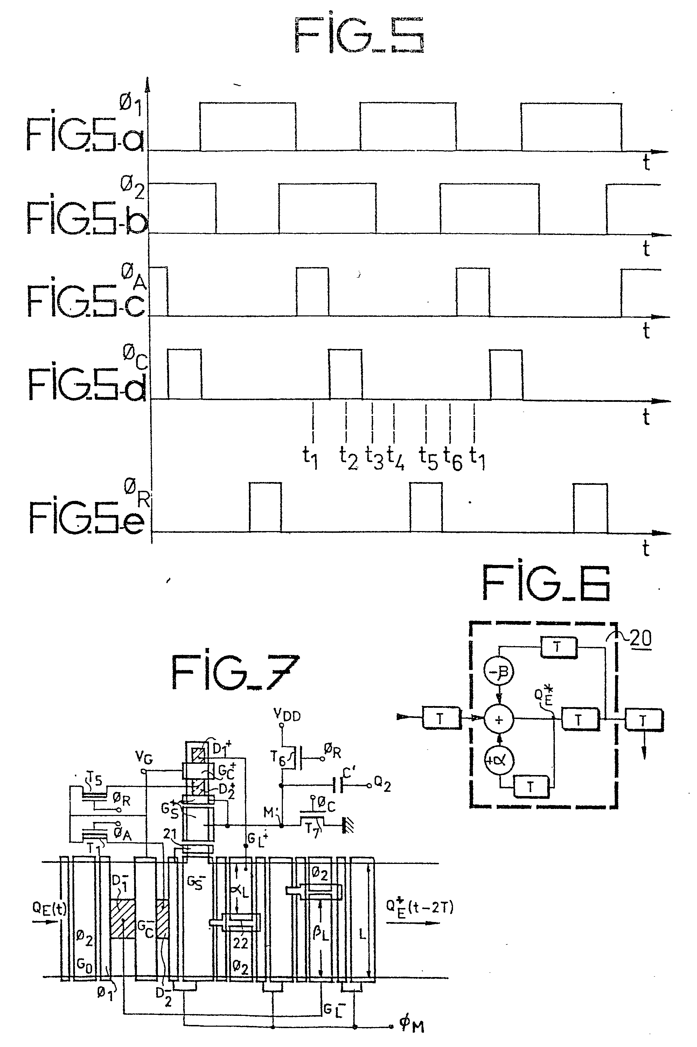

A titre d'exemple, deux applications du dispositif de lecture et d'injection selon l'invention, illustrées par les figures 4a, 4b et 7, vont maintenant être décrites.

La figure 3 représente un schéma d'un dispositif à transfert de charges qui comporte une partie récursive 13 à coefficients de pondération de même signe en série avec une partie non récursive 14. Le bouclage de la partie récursive se fait avec un gain K sur l'entrée négative d'un amplificateur différentiel 15 qui reçoit sur son entrée positive une quantité de charges correspondant à la tension d'entrée $V_E$ qui est appliquée à un dispositif d'injection des charges classique 16. La partie non récursive est reliée à un dispositif de lecture des charges en courant 17 et à un amplificateur de sortie 18 qui assure l'échantillonnage et le maintien de la tension de sortie $V_S$.

La transformée en z de la fonction de transfert de ce dispositif à transfert de charges s'écrit :

$$V_S(\omega)/V_E(\omega) = P(z)/1 + KQ(z) \cdot z^r, \tag{1}$$

où $P(z)$ et $Q(z)$ sont les transformées en z des fonctions de transfert des parties non récursive et récursive, où $z^r$ est le retard introduit par la partie récursive et où $z = e^{-j\omega T}$, $F = 1/T$ étant la fréquence d'échantillonnage du dispositif.

La figure 4a représente une vue de dessus d'un mode de réalisation selon l'invention du dispositif de la figure 3 et la figure 4b représente une vue en coupe transversale, selon le sens de transfert des charges, du dispositif de la figure 4a, ainsi qu'un schéma illustrant le fonctionnement de ce dispositif.

Le dispositif à transfert de charges est entièrement intégré sur le même substrat 1 recouvert d'une couche isolante 2.

On retrouve sur la figure 4a le dispositif de lecture et d'injection des charges représenté sur la figure 2a :
— la grille de lecture $G_L$ est constituée par la connexion d'une partie des différentes électrodes de stockage coupées 3 de la partie récursive 13 ;
— la diode $D_1$ est reliée à $G_L$ par une connexion métallique extérieure au substrat semi-conducteur ;
— la grille de commande $G_C$ est portée au potentiel $V_G$ par un transistor MOS $T_4$ fonctionnant en saturation et relié à une tension $V_{DD}'$ telle que $V_{DD} - V_T = V_G$ ;
— la diode $D_2$ est préchargée par un transistor MOS $T_1$ commandé par une phase $\phi_A$ et relié à $G_C$ ;
— enfin, en amont de la diode $D_1$, se trouve un couple électrode de stockage-électrode de transfert $G_O$, $G_P$ et en aval de la diode $D_2$ se trouve un couple électrode transfert-électrode de stockage $G_S$.

Le signal d'entrée à filtrer $V_E$ est injecté, superposé à une tension de référence $V_{réf}$, sur un dispositif d'injection des charges classique 16, constitué d'une diode d'entrée $D_E$, suivie d'une grille écran reliée à une tension $V_{DD'}$ d'une grille d'échantillonnage commandée par la phase $\phi_A$ et d'une grille de stockage $G_E$

maintenue à une tension fixe $V_{GE}$.

Le dispositif d'injection des charges 16 est suivi par un étage intermédiaire 19 constitué de deux couples électrode de transfert 4-électrode de stockage 3 reliés à deux phases $\phi_1$ et $\phi_2$ et suivis par la grille $G_P$ qui est reliée à la phase $\phi_1$.

On trouve ensuite, intégrés sur le substrat, la diode $D_1$, la grille $G_C$ et la diode $D_2$, puis la partie récursive 13. Dans la partie récursive, alternent deux sortes de couples électrode de transfert-électrode de stockage.

D'une part, des couples dans lesquels l'électrode de stockage n'est pas coupée, et qui sont reliés à un point M où est connecté un doubleur de tension constitué de façon connue d'une capacité C reliée à la phase $\phi_1$, de deux transistors MOS $T_2$ et $T_3$, commandés par une phase $\phi_C$ et la phase $\phi_A$ et reliés respectivement à la tension $V_{DD}$ et la masse.

D'autre part, des couples dans lesquels l'électrode de stockage est partagée en deux parties. Les électrodes de stockage sont reliées entre elles par une de leurs parties et constituent la grille de lecture $G_L$, tandis que les parties complémentaires sont reliées à la phase $\phi_2$. L'électrode de transfert de ces couples est également reliée à la phase $\phi_2$.

A la suite de la partie récursive, on trouve sur le substrat la partie non récursive avec ses électrodes coupées lues par un dispositif de lecture des charges 17.

Les diagrammes des figures 5a à 5d représentent en fonction du temps les signaux applicables au dispositif des figures 4a et 4b.

Les figures 5a à 5d représentent les potentiels $\phi_1$, $\phi_2$, $\phi_A$, $\phi_C$ qui sont des fonctions périodiques de même période T dont l'amplitude varie entre un niveau bas et un niveau haut. Les potentiels $\phi_1$ et $\phi_2$ d'une part et $\phi_A$ et $\phi_C$ d'autre part sont de préférence identiques mais déphasés.

Pendant la période T, les potentiels $\phi_1$ et $\phi_2$ sont plus longtemps au niveau haut qu'au niveau bas. Ces potentiels sont déphasés de façon que chacun d'eux passe au niveau bas, puis revienne au niveau haut alors que l'autre potentiel est au niveau haut.

Le potentiel $\phi_A$ passe au niveau haut lorsque $\phi_1$ passe au niveau bas. Le potentiel $\phi_C$ passe au niveau haut lorsque $\phi_A$ descend au niveau bas, puis descend au niveau bas lorsque $\phi_1$ monte au niveau haut.

Le fonctionnement du dispositif à transfert de charges représenté sur les figures 4a et 4b est le suivant :

Au temps $t_1$, $\phi_2$ et $\phi_A$ sont au niveau haut, $\phi_1$ et $\phi_C$ sont au niveau bas. Une quantité de charges $Q_{ref} + Q_E(t)$ est injectée sur $G_E$. Les charges-signal injectées précédemment sont transférées sous les électrodes coupées de la partie récursive par la remise à zéro du point M par le transistor $T_3$ commandé par $\phi_A$. Le transistor $T_1$ est conducteur et la diode $D_2$ est au potentiel $V_G$ appliqué sur $G_C$. Le potentiel sous $D_1$ s'aligne sur celui existant sous $G_C$ et égal à $V_G - V_T$. Les charges transférées sous $D_2$ par la diminution du potentiel sous $D_1$ lors de l'arrivée des charges signal sous les électrodes coupées sont ainsi évacuées à travers $T_1$.

La figure 4b représente l'évolution des potentiels dans le substrat. Le profil du potentiel au temps $t_1$ est représenté en trait discontinu.

On a supposé, à titre d'exemple, sur la figure 4b que la tension $V_{DD}$ égale 12 V et que les phases $\phi_1$, $\phi_2$, $\phi_A$, $\phi_C$ varient entre 0 et 21 V.

Le substrat du dispositif est porté à un potentiel VSS = – 5 V. La grille d'entrée $V_{GE}$ est au potentiel 5 V et enfin, la grille de commande $G_C$ est portée au potentiel $V_G = 9,5$ V, en supposant la tension de seuil du transistor $T_4$ égale à 2,5 V.

Au temps $t_2$, la phase $\phi_C$ passe au niveau haut et $\phi_A$ est au niveau bas. La diode $D_2$ est isolée et le point M est porté sensiblement 8 $V_{DD}$ égal à 12 V par le transistor $T_2$ commandé par $\phi_C$ qui charge la capacité C. Le profil du potentiel au temps $t_2$ est représenté en pointillés sur la figure 4b.

Au temps $t_3$, la phase $\phi_C$ revient à zéro et la phase $\phi_1$ passe au niveau haut. Le point M est porté à $V_{DD} + V_{\phi1}$, soit environ 24 V. Le potentiel sous les électrodes adjacentes aux électrodes coupées est tel qu'il se produit un transfert de charges des électrodes coupées sous les électrodes de stockage ajacentes. Par influence électrostatique, le potentiel de la diode $D_1$ augmente de la valeur $\Delta\phi_S$ telle que :

$$\Delta\phi_S = 1/C_L \cdot \sum_{i=1}^{n} h_i \cdot Q_E{}^*(t - iT) = Q_n(t)/C_L$$

où $C_L$ est la capacité totale de la grille de lecture $G_L$, n le nombre d'électrodes de stockage constituant la grille de lecture $G_L$ et $Q_E{}^*(t)$ la quantité de charges présente au temps $t + t_4$ sous l'électrode $G_S$.

Au temps $t_4$, le potentiel $\phi_2$ revient à zéro. Les charges $Q_{ref} + Q_E(t - T)$ présentes sous la grille $G_E$ sont transférées sous la diode $D_1$, $Q_E(t)$ étant la quantité de charges présentes sous l'électrode de stockage $G_O$ au temps $t + t_1$. La diode $D_1$ est restaurée au potentiel $V_G - V_T = 7$ V, l'excédent de charges est transféré sous la diode $D_2$ puis sous l'électrode de stockage $G_S$.

Cet excédent de charges s'écrit :

$$Q_E{}^*(t) = Q_{réf} + Q_E(t - T) - CL\ \Delta\phi_S = Q_{réf} + Q_E(t - T) - Q_n(t).$$

En passant dans le domaine des fréquences, la relation précédente s'écrit :

$$Q_E^*(\omega) = Q_E(\omega)e^{-j\omega T} - Q_n(\omega) = Q_E(\omega)e^{-j\omega T} - Q_E^*(\omega).$$

$$\sum_{i=1}^{n} h_i e^{-j\omega iT}$$

D'où :

$$\frac{Q_E^*(\omega)}{Q_E(\omega)} = \frac{e^{-j\omega T}}{1 + \sum_{i=1}^{n} h_i e^{-j\omega iT}} = \frac{z}{1 + Q(z)} \quad .$$

La transformée en z de la fonction de transfert de l'ensemble du dispositif à transfert de charges est donc égale à

$$P(z) \cdot z^{n+1}/1 + Q(z)$$

ce qui correspond bien à la formule théorique (1) dans le cas où le gain de boucle k égale 1 et où r = n + 1 car l'étage intermédiaire 19 comporte deux couples électrode de transfert-électrode de stockage et introduit un retard pur supplémentaire égal à T.

Le profil des potentiels au temps $t_4$ est représenté en trait plein sur la figure 4b.

Le dispositif représenté sur les figures 4a et 4b permet donc d'obtenir un filtre récursif du $n^{ième}$ ordre à coefficients de même signe en série avec un filtre non récursif.

Le dispositif à transfert de charges représenté sur les figures 4a et 4b doit comporter une partie récursive à coefficients de pondération de même signe pour que la réinjection soit toujours possible. La figure 7 représente un mode de réalisation selon l'invention d'un dispositif à transfert de charges, dont le schéma est représenté sur la figure 6, et qui comporte un coefficient positif et un coefficient négatif.

La figure 6 représente le schéma de principe d'une cellule récursive du deuxième ordre 20 ayant un coefficient positif $\alpha$ et un coefficient négatif $\beta$.

La réinjection du coefficient négatif $\beta$ se fait par une structure rigoureusement identique à celle qui est représentée sur la figure 4a, par lecture lors du départ des charges de la grille de lecture. On a désigné par $D_1^-$, $G_C^-$, $D_2^-$, les éléments du transistor d'injection, par $G_S^-$ le couple électrode de transfert-électrode de stockage qui suit $D_2^-$, et par $\phi_M$, le signal disponible au point M de la figure 4a.

La grille de lecture $G_L^-$ est constituée par une partie de longueur $\beta L$ d'une électrode de stockage de longueur L coupée en deux parties et reliée par une connexion métallique extérieure au substrat à la diode $D_1^-$.

La réinjection du coefficient positif $\alpha$ se fait grâce à un deuxième dispositif à transfert de charges, disposé perpendiculairement au dispositif à transfert de charges qui assure l'élaboration du coefficient négatif ; ce deuxième dispositif comporte un dispositif de lecture et d'injection des charges tel que celui représenté sur la figure 1 et où la lecture se fait lors de l'arrivée des charges sous la grille de lecture. Ce dispositif est constitué de deux diodes $D_1^+$ et $D_2^+$ et d'une grille de commande $G_C^+$, suivis par un couple électrode de transfert-électrode de stockage $G_S^+$, qui peut être mis en relation par l'intermédiaire d'une grille de transfert 21 reliée à $\phi_M$ avec la grille de stockage $G_S^-$ du premier substrat 1.

Les grilles de commande $G_C^+$ et $G_C^-$ sont portées au même potentiel $V_G$ et les diodes $D_2^+$ et $D_2^-$ sont reliées aux deux grilles $G_C^+$ et $C_C^-$ par l'intermédiaire de deux transistors MOS $T_5$ et $T_1$ commandés par les phases $\phi_R$ et $\phi_A$. Enfin, le couple électrode de transfert-électrode de stockage $G_S^+$ est relié au point M' à un doubleur de tension constitué d'une capacité C', reliée au potentiel $\phi_2$ et de deux transistors MOS $T_6$ et $T_7$ reliés à $V_{DD}$ et à la masse et commandés par $\phi_R$ et $\phi_C$.

Enfin la diode $D_1^+$ est reliée par une connexion métallique extérieure au substrat à une partie de longueur $\alpha L$ d'une électrode de stockage de longueur L coupée en deux parties qui constitue la grille de lecture $G_L^+$.

Le couple électrode de transfert-électrode de stockage $G_L^+$ suit, selon le sens de transfert des charges c'est-à-dire de gauche à droite, le couple électrode de transfert-électrode de stockage $G_S^-$ et précède un couple électrode de transfert-électrode de stockage entière relié à $\phi_M$ suivi par le couple électrode de transfert-électrode de stockage $G_L^-$.

Un filtre non récursif peut être intégré sur le même substrat à la suite du filtre récursif.

Le dispositif représenté sur la figure 7 peut être commandé par les potentiels $\phi_1$, $\phi_2$, $\phi_A$, $\phi_C$ représentés sur les figures 5a à 5d et par un potentiel $\phi_R$ représenté sur la figure 5e. Le potentiel $\phi_R$ est identique à $\phi_A$ et $\phi_C$ mais il est déphasé par rapport à ces potentiels. Le potentiel $\phi_R$ est au niveau haut alors que $\phi_1$ est au niveau haut, mais il passe au niveau bas avant $\phi_1$, alors que $\phi_2$ passe au niveau haut.

Le fonctionnement du dispositif représenté sur la figure 7 est le suivant :

Au temps $t_5$, la phase $\phi_R$ est au niveau haut. La diode $D_2^+$ est préchargée au potentiel $V_G$ par le transistor $T_5$, et le couple d'électrodes $G_S^+$ est porté au potentiel $V_{DD}$ par le transistor $T_6$ qui charge la capacité C'.

Au temps $t_6$, la phase $\phi_2$ est au niveau haut et la phase $\phi_R$ est au niveau bas. Par l'intermédiaire de la capacité C', le point M', et donc le couple d'électrodes $G_S{}^+$, est porté au potentiel $V_{DD} + V_{\phi 2}$. La diode $D_2{}^+$ est isolée.

Au temps $t_1$, la phase $\phi_A$ passe au niveau haut, la phase $\phi_M$ s'annule donc (voir figure 4a) et une quantité de charges $Q_E{}^*(t - T)$ est transférée sous la grille de lecture $G_L{}^+$. On appelle $Q_E{}^*(t)$ la quantité de charges présente sous l'électrode de stockage $G_S{}^-$ au temps $t + t_4$. Une diminution de potentiel se produit alors sous la diode $D_1{}^+$ et une quantité de charges $\alpha Q_E{}^*(t - T)$ est injectée sous la grille de stockage $G_S{}^+$.

Au temps $t_2$, la phase $\phi_C$ passe au niveau haut. L'électrode de stockage $G_S{}^+$ est ramenée à zéro, l'électrode de stockage $G_S{}^-$ et l'électrode de transfert 21 sont portées à $V_{DD}$. La quantité de charges $\alpha Q_E{}^*(t - 2T)$ est transférée sous $G_S{}^-$.

Au temps $t_4$, la quantité de charges $Q_E(t) - \beta Q_E{}^*(t - T)$ est transférée sous l'électrode de stockage $G_S{}^-$ par la lecture du coefficient négatif. On appelle $Q_E(t)$ la quantité de charges présente sous $G_O$ au temps $t + t_1$.

La quantité de charges présente sous l'électrode de stockage $G_S{}^-$ s'écrit alors :

$$Q_E{}^*(t) = Q_E(t) - \beta Q_E{}^*(t - 2T) + \alpha Q_E{}^*(t - T).$$

Dans le domaine des fréquences, la fonction de transfert du dispositif s'écrit :

$$Q_E{}^*(\omega)/Q_E(\omega) = 1/1 - \alpha z + \beta z^2$$

ce qui est bien la fonction de transfert du deuxième ordre, avec un coefficient positif et un coefficient négatif recherché.

La figure 7 représente donc un mode de réalisation selon l'invention d'une cellule récursive du deuxième ordre, représentée sur la figure 6, qui a un coefficient positif $\alpha$ et un coefficient négatif $\beta$.

L'intérêt de cette cellule est qu'un filtre récursif du $n^{\text{ième}}$ ordre peut se décomposer en une mise en série de cellules de ce type avec une diminution de la sensibilité des coefficients par rapport au filtre récursif du $n^{\text{ième}}$ ordre constitué par une seule cellule telle que celle représentée sur la figure 7 et dont les grilles de lecture $G_L{}^+$ et $G_L{}^-$ sont constituées de plusieurs électrodes coupées de longueurs $\alpha_1 L$, $\alpha_2 L$, ... et $\beta_1 L$, $\beta_2 L$ ...

La dynamique du dispositif de lecture et d'injection selon l'invention peut être augmentée en abaissant le seuil sous la grille de commande du transistor d'injection par une implantation du type N dans l'exemple où le substrat est de type P et en transformant ainsi le transistor d'injection en transistor MOS à déplétion.

Dans les parties récursives des dispositifs à transfert de charges représentés sur les figures 4a, 4b, et 7, le potentiel des portions d'électrodes coupées qui constituent la grille de lecture $G_L$ est plus faible que celui des autres portions d'électrodes coupées reliées au potentiel $\phi_2$. Le partage de la charge doit alors se faire de façon connue, sous l'électrode précédente où le potentiel est homogène grâce à des diffusions d'isolement 22, représentées sur la figure 7.


**Revendications**

1. Dispositif de lecture et d'injection de charges électriques assurant la lecture de charges dans un dispositif à transfert de charges, comportant un substrat semi-conducteur (1) recouvert d'une couche isolante (2) sur laquelle alternent des électrodes de transfert (4) et des électrodes de stockage (3) des charges, ces électrodes assurant, sur application de potentiels donnés, le transfert des charges dans le substrat et comportant, en outre, une diode d'injection des charges ($D_1$) qui est connectée électriquement à au moins une électrode de stockage des charges ($G_L$) associée aux charges ($Q_S$) à lire, cette diode étant suivie par une grille de commande ($G_C$) de sorte que, lors de l'arrivée des charges ($Q_S$) sous les électrodes de stockage (3), les charges injectées par influence électrique sous la diode d'injection ($D_1$) soient transférées au-dessous de ladite grille ($G_C$) vers une électrode de stockage suivante, caractérisé en ce que la diode d'injection des charges ($D_1$) et la grille de commande ($G_C$) forment en combinaison avec une deuxième diode ($D_2$), disposée à leur suite sur le substrat (1), un transistor MOS d'injection des charges polarisé en saturation, en ce que la diode ($D_2$) qui constitue le drain de ce transistor MOS est reliée à un transistor ($T_1$) qui est maintenu conducteur lors de l'arrivée des charges ($Q_S$) sous les électrodes de stockage, et donc lors de l'arrivée sous la source puis le drain du transistor d'injection ($D_1$, $G_C$, $D_2$) des charges fournies par influence électrique et, caractérisé en ce qu'un couple électrode de stockage-électrode de transfert ($G_O$, $G_P$), disposé en amont du transistor d'injection ($D_1$, $G_C$, $D_2$), selon le sens de transfert des charges, assure le transfert sous la source ($D_1$) du transistor d'injection d'une quantité de charges de référence ($Q_{réf}$), après le départ des charges des électrodes de stockage (3) qui provoque par influence électrique une augmentation de potentiel ($\Delta\phi_S$) sous la source ($D_1$) du transistor d'injection des charges, de sorte qu'une quantité de charges égale à la différence ($Q_{réf} - Q_S$) entre la quantité de charges de référence ($Q_{réf}$) et la quantité de charges à lire ($Q_S$) est transférée sous le drain ($D_2$) du transistor d'injection des charges, puis sous l'électrode de stockage suivante.

2. Dispositif selon la revendication 1, associé à un autre dispositif de lecture et d'injection qui diffère du dispositif selon la revendication 1 en ce que le transistor $(T_1)$ n'est pas conducteur lors de l'arrivée des charges $(Q_S)$ sous les électrodes de stockage (3), une quantité de charges $(Q_S)$ étant injectée par influence électrique sous la diode d'injection $(D_1)$ puis transférée sous la grille $(G_C)$ et l'autre diode $(D_2)$ vers une électrode de stockage suivante et, en ce que le transfert de la quantité de charges de référence $(Q_{réf})$ n'a pas lieu.

3. Dispositif selon l'une des revendications 1 ou 2, caractérisé en ce que le dispositif à transfert de charges dans lequel s'effectue la lecture et le dispositif à transfert de charges dans lequel le transistor MOS d'injection des charges se trouve intégré sont réalisés sur le même substrat semi-conducteur (1).

4. Dispositif selon l'une des revendications 1, 2 ou 3, caractérisé en ce que le transistor MOS d'injection des charges se trouve intégré dans le dispositif à transfert de charges dans lequel s'effectue la lecture des charges.

5. Dispositif selon l'une des revendications 1 à 4, caractérisé en ce que le transistor MOS d'injection des charges est un transistor MOS à déplétion.

6. Dispositif à transfert de charges comportant plusieurs filtres transversaux en série, caractérisé en ce qu'il comporte un dispositif selon la revendication 2 assurant la lecture des charges dans un filtre et l'injection d'une même quantité de charges dans le filtre suivant où se trouve intégré le transistor MOS d'injection des charges.

7. Dispositif à transfert de charges comportant plusieurs lignes à retard en série, caractérisé en ce qu'il comporte un dispositif selon la revendication 2 assurant la lecture des charges dans une ligne à retard et l'injection d'une même quantité de charges dans la ligne à retard suivante où se trouve intégré le transistor MOS d'injection des charges.

8. Filtre récursif du $n^{ième}$ ordre à coefficients de même signe (figures 3, 4), caractérisé en ce qu'il comporte un dispositif selon la revendication 1 qui assure le bouclage du filtre, la quantité de charges de référence correspondant au signal à traiter présent à l'entrée du filtre et le transistor MOS d'injection des charges $(D_1, G_2, D_2)$ se trouvant intégré sensiblement à l'entrée du filtre.

9. Filtre récursif du $n^{ième}$ ordre à coefficients positifs et négatifs (figures 6, 7), caractérisé en ce qu'il comporte un dispositif selon la revendication 1, réalisé sur un premier dispositif à transfert de charges, qui assure l'élaboration des coefficients négatifs du filtre, la quantité de charges de référence correspondant au signal à traiter présent à l'entrée du filtre, et le transistor MOS d'injection des charges $(D_1^-, G_C^-, D_2^-)$ se trouvant intégré sensiblement à l'entrée du filtre, et caractérisé en ce qu'il comporte un autre dispositif selon la revendication 2 qui assure l'élaboration des coefficients positifs du filtre et dont le transistor MOS d'injection des charges $(D_1^+, G_C^+, D_2^+)$ se trouve intégré sur un deuxième dispositif à transfert de charges, disposé perpendiculairement au premier.

**Claims**

1. Electric charge reading and injection device assuring the reading of charges in a charge transfer device, comprising a semiconductor substrate (1) covered by an insulating layer (2) on which transfer electrodes (4) are alternated with charge storage electrodes (3), these electrodes assuring the transfer of the charges within the substrate upon application of determined potentials, and further comprising a charge injection diode $(D_1)$ which is electrically connected with at least one charge storage electrode $(G_L)$ associated with the charges $(Q_S)$ to be read, this diode being followed by a control gate $(G_C)$ so that, upon arrival of the charges $(Q_S)$ beneath the storage electrodes (3), the charges injected by electric influence beneath the injection diode $(D_1)$ are transferred beneath said gate $(Q_C)$ towards the following storage electrode, characterized in that the charge injection diode $(D_1)$ and the control gate $(G_C)$, in combination with a second diode $(D_2)$ following the former on the substrate (1), form a MOS charge injection transistor which is biased in saturation, in that the diode $(D_2)$ forming the drain of this MOS transistor is connected to a transistor $(T_1)$ maintained in conductive state during the arrival of the charges $(Q_S)$ beneath the storage electrodes, and thus during the arrival of the charges generated by electrical influence beneath the source and subsequently beneath the drain of the injection transistor $(D_1, G_C, D_2)$, and characterized in that a storage electrode-transfer electrode couple $(G_O, G_P)$ located upstream from the injection transistor $(D_1, G_C, D_2)$ in the direction of the charge transfer assures the transfer of a reference charge quantity $(Q_{ref})$ beneath the source $(D_1)$ of the injection transistor following the departure of the charges from the storage electrodes (3), causing an increase of the potential $(\Delta\phi_S)$ beneath the source $(D_1)$ of the charge injection transistor by electrical influence, so that a charge quantity equal to the difference $(Q_{ref} - Q_S)$ between the reference charge quantity $(Q_{ref})$ and the charge quantity to be read $(Q_S)$ is transferred beneath the drain $(D_2)$ of the charge injection transistor and then beneath the following storage electrode.

2. Device in accordance with claim 1, associated with a further reading and injection device which is different from the device in accordance with claim 1, characterized in that the transistor $(T_1)$ is not in the conducting state during the arrival of the charges $(Q_S)$ beneath the storage electrodes (3), a charge quantity $(Q_S)$ being injected by electrical influence beneath the injection diode $(D_1)$ and then transferred beneath the gate $(G_C)$ and the other diode $(D_2)$ towards the following storage electrode, and in that the

**0 017 561**

transfer of the reference charge quantity (Q_ref) is not performed.

3. Device in accordance with any of claims 1 and 2, characterized in that the charge transfer device in which the reading is performed and the charge transfer device into which the MOS charge injection transistor is integrated, are formed on the same semi-conductor substrate (1).

4. Device in accordance with any of claims 1, 2 or 3, characterized in that the charge injection MOS transistor is integrated into the charge transfer device in which the reading of the charges is performed.

5. Device in accordance with any of claims 1 to 4, characterized in that the MOS charge injection transistor is a depletion MOS transistor.

6. Charge transfer device comprising a plurality of transverse filters connected in series, characterized in that it comprises a device in accordance with claim 2 assuring the reading of the charges in a filter and the injection of the same charge quantity into the following filter into which the charge injection MOS transistor is integrated.

7. Charge transfer device comprising a plurality of delay lines connected in series, characterized in that it comprises a device in accordance with claim 2 assuring the reading of the charges in a delay line and the injection of the same charge quantity into the following delay line into which the charge injection MOS transistor is integrated.

8. Recursive filter of ith order having coefficients of the same sign (Figures 3, 4), characterized in that it comprises a device in accordance with claim 1 assuring the looping of the filter, the reference charge quantity corresponding to the signal to be processed presented to the input of the filter, and the charge injection MOS transistor ($D_1$, $G_C$, $D_2$) being integrated substantially at the input of the filter.

9. Recursive filter of ith other having positive and negative coefficients (Figures 6, 7), characterized in that it comprises a device in accordance with claim 1 formed on a first charge transfer device assuring the generation of the negative coefficients of the filter, the reference charge quantity corresponding to the signal to be processed and presented to the input of the filter, and the charge injection MOS transistor ($D_1$, $G_C$, $D_2$) being integrated substantially at the input of the filter, and characterized in that it comprises a further device in accordance with claim 2 assuring the generation of the positive coefficients of the filter and the charge injection MOS transistor ($D_1^+$, $G_C^+$, $D_2^+$) of which is integrated on the second charge transfer device arranged perpendicularly to the first.

## Ansprüche

1. Vorrichtung zum Auslesen und Injizieren von elektrischen Ladungen, welche in einer Ladungsverschiebevorrichtung das Auslesen der Ladungen gewährleistet, mit einem Halbleitersubstrat (1), das von einer Isolierschicht (2) bedeckt ist, auf welcher Verschiebeelektroden (4) mit Ladungsspeicherelektroden (3) abwechseln, wobei diese Elektroden beim Anlegen von gegebenen Potentialen die Verschiebung der Ladungen in dem Substrat gewährleisten, und ferner mit einer Ladungsinjektionsdiode ($D_1$), die elektrisch mit wenigstens einer Ladungsspeicherelektrode ($G_L$) verbunden ist, die den auszulesenden Ladungen ($Q_S$) zugeordnet ist, wobei auf diese Diode eine Steuerelektrode ($G_C$) folgt, so daß bei der Ankunft der Ladungen ($Q_S$) unter den Speicherelektroden (3) die durch elektrische Influenz unter der Injektionsdiode ($D_1$) injizierten Ladungen unter die genannte Steuerelektrode ($G_C$) und zu der darauffolgenden Speicherelektrode verschoben werden, dadurch gekennzeichnet, daß die Ladungsinjektionsdiode ($D_1$) und die Steuerelektrode ($G_C$) in Kombination mit einer zweiten, auf dem Substrat (1) nachfolgend angeordneten Diode ($D_2$) einen MOS-Transistor zur Injektion von Ladungen bilden, welcher in Sättigung polarisiert ist, daß die die Drain-Elektrode dieses MOS-Transistors bildende Diode ($D_2$) mit einem Transistor ($T_1$) verbunden ist, der während der Ankunft der Ladungen ($Q_S$) unter den Speicherelektroden, d. h. bei der Ankunft der durch elektrische Influenz gelieferten Ladungen unter der Source-Elektrode und anschließend unter der Drain-Elektrode des Injektions-transistors ($D_1$, $G_C$, $D_2$), leitend gehalten ist, und ferner dadurch gekennzeichnet, daß ein Elektrodenpaar aus einer Speicherelektrode und einer Verschiebeelektrode ($G_O$, $G_P$), das in Verschieberichtung der Ladungen vor dem Injektionstransistor ($D_1$, $G_C$, $D_2$) angeordnet ist, nachdem die Ladungen die Speicherelektroden (3) verlassen haben, die Verschiebung einer Bezugsladungsmenge ($Q_{ref}$) unter die Source-Elektrode ($D_1$) des Injektionstransistors gewährleistet, die durch elektrische Influenz eine Potentialvergrößerung ($\Delta\phi_S$) unter der Source-Elektrode ($D_1$) des Ladungsinjektionstransistors hervorruft, so daß eine Ladungsmenge, die gleich der Differenz ($Q_{ref} - Q_S$) zwischen der Bezugsladungsmenge ($Q_{ref}$) und der auszulesenden Ladungsmenge ($Q_S$) ist, unter die Drain-Elektrode ($D_2$) des Ladungsinjektionstransistors und dann unter die darauffolgende Speicherelektrode verschoben wird.

2. Vorrichtung nach Anspruch 1, die einer weiteren Auslese- und Injektionsvorrichtung zugeordnet ist, welche von der Vorrichtung nach Anspruch 1 verschieden ist, dadurch gekennzeichnet, daß der Transistor ($T_1$) während der Ankunft der Ladungen ($Q_S$) unter den Speicherelektroden (3) nichtleitend ist, wobei eine Ladungsmenge ($Q_S$) durch elektrische Influenz unter der Injektionsdiode ($D_1$) injiziert und anschließend unter die Steuerelektrode ($G_C$) und die andere Diode ($D_2$) sowie zu der darauffolgenden Speicherelektrode verschoben wird, und daß die Verschiebung der Bezugsladungsmenge ($Q_{ref}$) nicht erfolgt.

3. Vorrichtung nach Anspruch 1 oder 2, dadurch gekennzeichnet, daß die Ladungsverschiebe-

9

vorrichtung, in der das Auslesen erfolgt, und die Ladungsverschiebevorrichtung, in welcher der MOS-Ladungsinjektionstransistor integriert ist, auf demselben Halbleitersubstrat (1) verwirklicht sind.

4. Vorrichtung nach einem der Ansprüche 1, 2 und 3, dadurch gekennzeichnet, daß der MOS-Ladungsinjektionstransistor in die Ladungsverschiebevorrichtung integriert ist, in welcher das Auslesen der Ladungen erfolgt.

5. Vorrichtung nach einem der Ansprüche 1 bis 4, dadurch gekennzeichnet, daß der MOS-Ladungsverschiebetransistor ein MOS-Transistor vom Verarmungstyp ist.

6. Ladungsverschiebevorrichtung mit mehreren in Reihe liegenden Transversalfiltern, dadurch gekennzeichnet, daß sie eine Vorrichtung nach Anspruch 2 umfaßt, die das Auslesen der Ladungen in einem Filter und das Injizieren derselben Ladungsmenge in das darauffolgende Filter gewährleistet, in welches der MOS-Ladungsinjektionstransistor integriert ist.

7. Ladungsverschiebevorrichtung mit mehreren in Reihe liegenden Verzögerungsleitungen, dadurch gekennzeichnet, daß sie eine Vorrichtung nach Anspruch 2 umfaßt, welche das Auslesen der Ladungen aus einer Verzögerungsleitung und das Injizieren derselben Ladungsmenge in die darauffolgende Verzögerungsleitung gewährleistet, in die der MOS-Ladungsinjektionstransistor integriert ist.

8. Rekursives Filter i-ter Ordnung mit Koeffizienten desselben Vorzeichens (Figuren 3 und 4), dadurch gekennzeichnet, daß es eine Vorrichtung nach Anspruch 1 umfaßt, welche die Rückschleifung des Filters gewährleistet, wobei die Bezugsladungsmenge dem zu verarbeitenden Signal entspricht, das am Eingang des Filters vorhanden ist, und wobei der MOS-Ladungsinjektionstransistor ($D_1$, $G_C$, $D_2$) im wesentlichen am Eingang des Filters integriert ist.

9. Rekursives Filter i-ter Ordnung, mit positiven und negativen Koeffizienten (Figuren 6, 7), dadurch gekennzeichnet, daß es eine Vorrichtung nach Anspruch 1 umfaßt, die auf einer ersten Ladungsverschiebevorrichtung verwirklicht ist, welche die Erzeugung der negativen Koeffizienten des Filters gewährleistet, wobei die Bezugsladungsmenge dem zu verarbeitenden Signal entspricht, das am Eingang des Filters vorhanden ist, und wobei der MOS-Ladungsinjektionstransistor ($D_1$, $G_C$, $D_2$) im wesentlichen am Eingang des Filters integriert ist, und ferner dadurch gekennzeichnet, daß es eine weitere Vorrichtung nach Anspruch 2 umfaßt, welche die Erzeugung der positiven Koeffizienten des Filters gewährleistet und deren MOS-Ladungsinjektionstransistor ($D_1^+$, $G_C^+$, $D_2^+$) auf einer zweiten Ladungsverschiebevorrichtung integriert ist, die senkrecht zu der ersteren angeordnet ist.

# FIG_1

# FIG_2

## FIG_2a

## FIG_2-b

0 017 561

# FIG_3

# FIG_4_a    FIG_4

# FIG_4_b

2

# FIG_5

FIG.5-a
$\phi_1$

FIG.5-b
$\phi_2$

FIG.5-c
$\phi_A$

FIG.5-d
$\phi_C$

$t_1$  $t_2$  $t_3 t_4$   $t_5$  $t_6$  $t_1$

FIG.5e
$\phi_R$

# FIG_6

# FIG_7